# EUROPÄISCHE PATENTSCHRIFT

(11) **EP 3 227 163 B1**
(45) Veröffentlichungstag und Bekanntmachung des Hinweises auf die Patenterteilung: **22.05.2019**
(21) Anmeldenummer: 15812970.0
(22) Anmeldetag: 25.11.2015
(51) Int. Cl.: B62D 1/06, B62D 1/04, H03K 17/96, H03K 17/955, B60N 2/00

(54) **LENKRAD FÜR EIN KRAFTFAHRZEUG MIT EINEM SENSORSYSTEM UND VERFAHREN ZUM ERKENNEN EINER ANWESENHEIT EINER MENSCHLICHEN HAND IN EINEM GREIFBEREICH EINES LENKRADS**
STEERING FOR A VEHICLE WITH A SENSOR SYSTEM AND METHOD TO DETECT A HUMAN HAND IN A GRIP AREA OF A STEERING WHEEL
VOLANT POUR UN VÉHICULE AVEC UN CAPTEUR SYSTÈME ET PROCÉDÉ POUR DÉTECTER UNE MAIN HUMAINE DANS UNE ZONE DE PRISE DU VOLANT

(30) Priorität: 04.12.2014 DE 102014117824
(43) Veröffentlichungstag der Anmeldung: 11.10.2017
(73) Patentinhaber: Valeo Schalter und Sensoren GmbH, 74321 Bietigheim-Bissingen (DE)
(72) Erfinder: STAUDE, Sascha, 74321 Bietigheim-Bissingen (DE); MAYR, Alexander, 74321 Bietigheim-Bissingen (DE); KAISER, Frank, 74321 Bietigheim-Bissingen (DE)
(86) Internationale Anmeldenummer: PCT/EP2015/077617
(87) Internationale Veröffentlichungsnummer: WO 2016/087279

(56) Entgegenhaltungen:
- WO-A1-2011/080323
- WO-A1-2013/117719
- DE-A1-102011 084 903
- DE-A1-102012 024 903

## Beschreibung

Die Erfindung betrifft ein Lenkrad für ein Kraftfahrzeug mit einem Sensorsystem mit einer kapazitiven Sensoreinrichtung, wobei das Sensorsystem zum Erkennen einer Anwesenheit einer menschlichen Hand in einem Greifbereich des Lenkrads ausgebildet ist und wenigstens eine, in einem Greifbereich des Lenkrads angeordnete, elektrisch leitfähige Sensorstruktur mit einem Detektionsbereich aufweist, wobei das Sensorsystem derart ausgebildet ist, dass die Anwesenheit einer menschlichen Hand im Detektionsbereich der Sensoreinrichtung einem Referenzzustand gegenüber jeweils eine erfassbare, der Sensorstruktur zugeordnete Änderung einer kapazitiven Kopplung der Sensorstruktur mit der Umgebung und/oder einer Referenzelektrode bewirkt, wobei das Sensorsystem dazu ausgebildet ist, diese Änderung der kapazitiven Kopplung der zu sensierenden Sensorstruktur mit der Umgebung und/oder einer Referenzelektrode zu erfassen, so dass infolgedessen die Anwesenheit einer menschlichen Hand im Greifbereich des Lenkrads erkannt werden kann, wobei das Lenkrad eine Abschirmeinrichtung mit wenigstens einem Abschirmelement aufweist, wobei die Abschirmeinrichtung eine Abschirmung der Sensoreinrichtung gegenüber störenden kapazitiven Kopplungen mit Komponenten des Lenkrads bewirkt.

Außerdem betrifft die Erfindung ein Verfahren zum Erkennen einer Anwesenheit einer menschlichen Hand in einem Greifbereich eines Lenkrads für ein Kraftfahrzeug, insbesondere zum Erkennen der Anwesenheit einer menschlichen Hand im Greifbereich eines vorbeschriebenen Lenkrads.

Sensorsysteme für Lenkräder von Kraftfahrzeugen zur Erkennung einer Anwesenheit einer menschlichen Hand in einem Greifbereich eines Lenkrads, insbesondere zur Hands-On-Off-Erkennung, mit kapazitiven Sensoreinrichtungen, auch in Kombination mit in das Lenkrad integrierten Heizeinrichtungen, sind aus dem Stand der Technik grundsätzlich bekannt, beispielsweise aus der DE 203 09 603 U1, der EP 1 491 409 B1, der DE 10 2009 058 138 A1, der WO 2013/117719 A1 oder der DE 10 2011 084 903 A1.

Die Sensorgenauigkeit bzw. die Sensorempfindlichkeit einer kapazitiven Sensoreinrichtung ist dabei umso höher, je geringer die Störeinflüsse sind, welche auf die kapazitive Sensoreinrichtung wirken, wobei insbesondere ein elektrischer Leiter, wie beispielsweise ein Heizleiter oder ein metallischer Lenkradkern, im elektrischen Feld einer Sensorkapazität eine störende kapazitive Kopplung bewirken kann. Maßnahmen zur Verringerung der Störeinflüsse auf die kapazitive Sensoreinrichtung, insbesondere zur Verringerung sogenannter parasitärer kapazitiver Kopplungen mit der Sensoreinrichtung, sind dabei aus dem Stand der Technik ebenfalls grundsätzlich bekannt.

Die vorgenannte WO 2013/117719 A1 lehrt beispielsweise, dass durch die Anordnung eines flächigen Abschirmelements zwischen dem metallischen Lenkradkern und der Sensoreinrichtung Störeinflüsse auf die kapazitive Sensoreinrichtung durch den metallischen Lenkradkern verringert werden können.

Um Störeinflüsse durch eine Heizeinrichtung zu verringern, schlägt die DE 10 2011 084 903 A1 gemäß Oberbegriff der Ansprüche 1 und 6 ebenfalls die Verwendung eines flächigen Abschirmelementes vor und die Heizeinrichtung dabei auf der dem metallischen Lenkradkern zugewandten Innenseite des Abschirmelementes anzuordnen, d.h. zwischen der Heizeinrichtung und der Sensoreinrichtung. Des Weiteren ist in diesem Dokument beschrieben, dass die Abschirmung der Heizeinrichtung weiter verbessert werden kann, wenn das Abschirmelement elektrisch leitfähig ist und mit einem elektrischen Potenzial beaufschlagt werden kann.

Es ist Aufgabe der Erfindung, ein Lenkrad mit einer kapazitiven Sensoreinrichtung zum Erkennen einer Anwesenheit einer menschlichen Hand in einem Greifbereich des Lenkrads bereitzustellen, das eine vorteilhaftere Abschirmeinrichtung zur Abschirmung der Sensoreinrichtung gegenüber einem Lenkradkern und/oder einer in das Lenkrad integrierten Heizeinrichtung aufweist, insbesondere eine Abschirmeinrichtung, mit welcher gegenüber den aus dem Stand der Technik bekannten Abschirmeinrichtungen eine verbesserte Abschirmung gegenüber Komponenten des Lenkrads erreicht werden kann.

Diese Aufgabe wird durch ein erfindungsgemäßes Lenkrad sowie durch ein erfindungsgemäßes Verfahren gemäß den jeweiligen unabhängigen Patentansprüchen gelöst. Vorteilhafte Ausführungen der Erfindung sind Gegenstand der abhängigen Patentansprüche, der Beschreibung und der Figuren.

Ein erfindungsgemäßes Lenkrad ist dadurch gekennzeichnet, dass das Abschirmelement elektrisch leitfähig ist und während einer Erfassung der Änderung der kapazitiven Kopplung wenigstens einer Sensorstruktur mit der Umgebung und/oder einer Referenzelektrode mit einem definierten, elektrischen Potenzial beaufschlagbar ist, das einem während der Erfassung der Änderung der kapazitiven Kopplung an der Sensorstruktur anliegenden Potenzial zumindest teilweise nachgeführt ist.

D.h. erfindungsgemäß ist das Abschirmelement als aktives Abschirmelement schaltbar, d.h. als sogenannter "Guard" bzw. als Schirmungselektrode betreibbar. Sind mehrere Abschirmelemente vorhanden, sind vorzugsweise mehrere Abschirmelemente entsprechend elektrisch leitfähig und mit einem elektrischen Potenzial beaufschlagbar, insbesondere alle Abschirmelemente.

Unter einem nachgeführten Potenzial wird dabei ein Potenzial verstanden, dass zunimmt, wenn das an der Sensorstruktur anliegende Potenzial zunimmt bzw. das abnimmt, wenn das an der Sensorstruktur anliegende Potenzial abnimmt.

Dadurch kann das sich zwischen der Sensorstruktur und der Umgebung und/oder einer Referenzelektrode aufgrund der kapazitiven Kopplung bildende elektrische Feld positiv beeinflusst werden, insbesondere derart, dass eine Grundkapazität der Sensoreinrichtung verringert wird, so dass die Anwesenheit einer menschlichen Hand, insbesondere eine Annäherung und/oder eine Entfernung einer menschlichen Hand, eine größere Änderung der kapazitiven Kopplung bewirkt und somit messtechnisch einfacher und genauer und damit zuverlässiger erfasst werden kann. D.h. mit anderen Worten kann durch die Verwendung eines aktiven Abschirmelements die Auflösung des Sensorsystems verbessert werden, insbesondere das Signal-zu-Rausch-Verhältnis (SNR = Signal to Noise Ratio), wodurch die Erkennungsqualität erheblich gesteigert werden kann.

Bevorzugt kann das Potenzial, mit welchem das Abschirmelement beaufschlagt werden kann, dabei dem an der Sensorstruktur anliegenden Potenzial nicht nur nachgeführt werden, sondern kann dem Verlauf des an der Sensorstruktur anliegenden Potenzials folgen. D.h. das Potenzial, mit welchem das Abschirmelement beaufschlagt werden kann, verläuft vorzugsweise im Wesentlichen entlang der gleichen Kurve, wie das an der Sensorstruktur anliegende Potenzial.

Besonders bevorzugt kann das Abschirmelement dabei mit dem gleichen absoluten elektrischen Potenzial beaufschlagt werden, das an der Sensorstruktur anliegt, d.h. mit den gleichen, absoluten Potenzialwerten. Dadurch kann die Grundkapazität des Sensorsystems in vielen Fällen nahezu auf null reduziert werden, so dass sich eine besonders hohe Auflösung des Sensorsystems erreichen lässt. D.h. dadurch kann erreicht werden, dass eine Annäherung und/oder Entfernung einer menschlichen Hand eine ausreichend große Änderung der kapazitiven Kopplung der Sensorstruktur mit der Umgebung und/oder einer Referenzelektrode bewirkt, die messtechnisch sicher erfasst werden kann. Je besser das elektrische Potenzial, mit welchem das Abschirmelement beaufschlagt wird, dem an der Sensorstruktur anliegendem Potenzial folgt, desto eine besser ist die erreichbare Abschirmwirkung.

Es hat sich herausgestellt nach der Erfindung, dass eine besonders gute Abschirmwirkung erreicht wird,
wenn die Erfassung einer Änderung der kapazitiven Kopplung der Sensorstruktur mit der Umgebung und/oder einer Referenzelektrode mittels des von der Firma "Microchip" entwickelten CVD (Capacitive Voltage Divider)-Verfahrens erfolgt. Dabei ermöglichen sowohl das sogenannte CVD-Self-Verfahren, bei welchem die Änderung der kapazitiven Kopplung der Sensorstruktur mit der Umgebung erfasst wird, als auch das sogenannte CVD-Mutual-Verfahrens, bei welchem die Änderung der kapazitiven Kopplung der Sensorstruktur mit einer Referenzelektrode erfasst wird, mit dem für diese beiden Verfahren charakteristischen, resultierenden Verlauf des während der Erfassung an der Sensorstruktur anliegenden Potenzials eine gute Abschirmung.

Vorzugsweise ist ein erfindungsgemäßes Lenkrad somit bevorzugt zur Erfassung einer Änderung der kapazitiven Kopplung der Sensorstruktur mit der Umgebung und/oder einer Referenzelektrode mittels des von der Firma "Microchip" entwickelten CVD (Capacitive Voltage Divider)-Verfahrens ausgebildet, insbesondere zur Erfassung mittels des CVD-Self-Verfahrens und/oder des CVD-Mutual-Verfahrens, insbesondere zur Erfassung der Änderung der kapazitiven Kopplung der Sensorstruktur durch das CVD-Self-Verfahren in Kombination mit dem CVD-Mutual-Verfahren.

In einer besonders vorteilhaften Ausgestaltung ist das Lenkrad jedoch zur Erfassung der Änderung der kapazitiven Kopplung mittels des folgenden, beschriebenen Verfahrens, welches eine Weiterentwicklung des von der Firma "Microchip" entwickelten CVD-Verfahrens darstellt, ausgebildet. Das bevorzugt eingesetzte Verfahren ist dadurch gekennzeichnet, dass zum Erkennen der Anwesenheit einer menschlichen Hand im Greifbereich des Lenkrads, insbesondere zum Erfassen der Änderung der kapazitiven Kopplung der zu sensierenden Sensorstruktur mit der Umgebung, in einem ersten Abtastzyklus in einem ersten Schritt eine Referenzkapazität und eine von der Sensorstruktur und der Umgebung gebildete Messkapazität jeweils mit einem definierten elektrischen Potenzial aufgeladen werden, wobei die Referenzkapazität mit einem ersten elektrischen Potenzial aufgeladen wird und die Messkapazität mit einem zweiten elektrischen Potenzial, in einem weiteren Schritt die Referenzkapazität und die von der Sensorstruktur und der Umgebung gebildete Messkapazität kurzgeschlossen werden, und in einem weiteren Schritt das sich zwischen der Messkapazität und der Referenzkapazität einstellende, resultierende elektrische Potenzial erfasst wird, wobei sich das resultierende elektrische Potenzial in Abhängigkeit vom ersten und zweiten elektrischen Potenzial sowie in Abhängigkeit von der Größe der Referenzkapazität und in Abhängigkeit von der Größe der Messkapazität einstellt.

In einem zweiten Abtastzyklus wird vorzugsweise im ersten Schritt die Referenzkapazität mit dem zweiten elektrischen Potenzial aufgeladen und die Messkapazität mit dem ersten elektrischen Potenzial, in einem weiteren Schritt werden dann vorzugsweise die Referenzkapazität und die von der Sensorstruktur und der Umgebung gebildete Messkapazität kurzgeschlossen, und in einem weiteren Schritt wird insbesondere das sich zwischen der Messkapazität und der Referenzkapazität einstellende, resultierende elektrische Potenzial erfasst, wobei sich das resultierende elektrische Potenzial in Abhängigkeit vom ersten und zweiten Potenzial sowie in Abhängigkeit von der Größe der Referenzkapazität und in Abhängigkeit von der Größe der Messkapazität einstellt.

Weist das Sensorsystem eine Referenzelektrode auf und bewirkt die Anwesenheit einer menschlichen Hand im Detektionsbereich einer Sensoreinrichtung einem Referenzzustand gegenüber eine erfassbare, der Sensorstruktur zugeordnete Änderung einer kapazitiven Kopplung der Sensorstruktur mit der Referenzelektrode, wird bevorzugt in einem weiteren Abtastzyklus, insbesondere in einem zweiten Abtastzyklus und/oder einem dritten und/oder vierten Abtastzyklus, vorzugsweise zusätzlich, in einem ersten Schritt jeweils die Referenzelektrode mit einem definierten elektrischen Potenzial beaufschlagt und in einem weiteren Schritt die kapazitive Kopplung der Sensorstruktur mit der Referenzelektrode erfasst, wobei die ermittelten Änderungen anschließend bevorzugt für die Auswertung miteinander verrechnet werden.

Bevorzugt wird nacheinander, vorzugsweise im Wechsel, insbesondere alternierend, die Änderung der kapazitiven Kopplung der Sensorstruktur mit der Umgebung und die Änderung der kapazitiven Kopplung der Sensorstruktur mit der Referenzelektrode erfasst.

Die Änderung der kapazitiven Kopplung der Sensorstruktur kann aber auch mithilfe eines Ladevorgangs, bei dem beispielsweise eine Stromänderung erfasst wird, gemessen werden, oder mittels anderer, entsprechend geeigneter Methoden, wie beispielsweise mittels eines Schwingkreises.

In einer vorteilhaften Ausgestaltung ist das elektrisch leitfähige Abschirmelement eines erfindungsgemäßen Lenkrads teilweise flächig ausgebildet und weist eine Außenseite und eine Innenseite auf und ist derart im Lenkrad angeordnet, dass die Innenseite einem Lenkradkern zugewandt ist und die Außenseite wenigstens einer Sensorstruktur, wobei das Abschirmelement den Lenkradkern zumindest teilweise umgreift. Die kapazitive Entkopplung vom Lenkradkern ist dabei umso besser, je mehr das Abschirmelement den Lenkradkern umgreift.

Durch die Anordnung einer beschriebenen Abschirmeinrichtung mit einem flächigen Abschirmelement zwischen dem Lenkradkern und der kapazitiven Sensoreinrichtung kann eine besonders gute, kapazitive Entkopplung der Sensoreinrichtung vom Lenkradkern und damit eine gute Abschirmung der kapazitiven Sensoreinrichtung gegenüber dem Lenkradkern erreicht werden, insbesondere gegenüber einem metallischen Lenkradkern.

Das Abschirmelement erstreckt sich dabei bevorzugt zumindest teilweise, insbesondere vollständig, sowohl in Umfangsrichtung, d.h. entlang des Lenkradkranzes, als auch in Umfassungsrichtung, d.h. senkrecht dazu in Gegenrichtung, um den Lenkradkern herum. Je besser das Abschirmelement dabei in einem funktionsgemäßen Einbauzustand des Sensorsystems in einem Lenkrad die Sensoreinrichtung von dem Lenkradkern abschirmt bzw. kapazitiv entkoppelt, desto besser kann eine störende kapazitive Kopplung der Sensoreinrichtung mit dem Lenkradkern vermieden werden und somit infolgedessen die Erkennungsgenauigkeit bzw. die Sensorempfindlichkeit erhöht werden.

In einer bevorzugten Ausgestaltung ist das Abschirmelement einteilig ausgebildet. Selbstverständlich kann das Abschirmelement aber auch mehrteilig ausgebildet sein.

Weist die Sensoreinrichtung mehrere Sensorstrukturen und/oder zusätzliche eine oder mehrere Heizstrukturen auf, sind in einer bevorzugten Ausgestaltung sämtliche Sensorstrukturen und/oder sämtliche Heizstrukturen auf der Außenseite des Abschirmelementes angeordnet, d.h. auf der dem Greifbereich zugewandten Seite. Besonders bevorzugt sind dabei sämtliche Sensor- und Heizstrukturen auf der Außenseite des Abschirmelementes angeordnet. Vorteilhaft an dieser Anordnung, bei der die Abschirmeinrichtung bzw. das Abschirmelement, in radialer Richtung betrachtet, auf der Innenseite einer Heizeinrichtung angeordnet ist, dass die von der Heizeinrichtung abgegebene Wärme nicht erst das Abschirmelement passieren muss, um den Greifbereich des Lenkrades zu beheizen.

Weist das Lenkrad eine Heizeinrichtung auf, wobei die Heizeinrichtung wenigstens eine elektrisch leitfähige Heizstruktur zur Heizung des Lenkrades aufweist, bildet vorzugsweise wenigstens eine Heizstruktur ein Abschirmelement und ist dazu mit einem definierten, elektrischen Potenzial beaufschlagbar, das einem während der Erfassung der Änderung der kapazitiven Kopplung an der Sensorstruktur anliegenden Potenzial zumindest teilweise nachgeführt ist, insbesondere mit einem Potenzial, das dem Verlauf des an der Sensorstruktur anliegenden Potenzials folgt. Dabei ist die Heizstruktur vorzugsweise derart ausgebildet, dass die Beaufschlagung der Heizstruktur mit dem definierten elektrischen Potenzial eine Abschirmung der Sensoreinrichtung gegenüber störenden kapazitiven Kopplungen mit Komponenten des Lenkrads bewirkt, insbesondere gegenüber dem Lenkradkern.

D.h., wenn das Lenkrad eine Heizeinrichtung mit wenigstens einer lektrisch leitfähigen Heizstruktur aufweist, dass in einer besonders bevorzugten Ausgestaltung wenigstens eine Heizstruktur als aktives Abschirmelement betrieben werden kann, wobei die Heizstruktur insbesondere alternativ oder zusätzlich zu einem anderen Abschirmelement, beispielsweise alternativ oder zusätzlich zu einem vorbeschriebenen, flächigen Abschirmelement, als aktives Abschirmelement betrieben werden kann. Die Verwendung einer Heizstruktur als Abschirmelement hat insbesondere den Vorteil, dass auf besonders einfache Art und Weise eine sich nachteilig auf die Erkennungsqualität einer Annäherung und/oder Entfernung einer menschlichen Hand auswirkende kapazitive Kopplung der Sensoreinrichtung mit der Heizeinrichtung im Zeitpunkt der Messung vermieden werden kann, insbesondere ohne die Anordnung eines zusätzlichen Abschirmelements zwischen der Heizeinrichtung und der Sensoreinrichtung.

Außerdem kann durch das Betreiben wenigstens einer Heizstruktur als aktives Abschirmelement eine störende Kopplung der Sensoreinrichtung mit dem Lenkradkern reduziert bzw. vermieden werden, was insbesondere im Fall eines metallischen Lenkradkerns vorteilhaft ist.

Das Betreiben wenigstens einer Heizstruktur als aktives Abschirmelement wirkt sich besonders vorteilhaft aus, wenn die als aktives Abschirmelement betriebene Heizstruktur mit wenigstens einer Sensorstruktur in derselben Ebene angeordnet ist, da auf diese Weise eine besonders gute Abschirmung dieser Sensorstruktur von umgebenden Kapazitäten erreicht werden kann, so dass eine noch größere Steigerung der Auflösung erzielt werden kann.

Es versteht sich von selbst, dass während der Zeit, in der die Heizstruktur als aktives Abschirmelement betrieben werden kann, kein Heizbetrieb dieser Heizstruktur möglich ist.

Weist das Lenkrad einen metallischen Lenkradkern auf, hat es sich als besonders vorteilhaft erwiesen, den Lenkradkern als aktives Abschirmelement zu betreiben und mit einem definierten, elektrischen Potenzial zu beaufschlagen, das einem während der Erfassung der Änderung der kapazitiven Kopplung an der Sensorstruktur anliegenden Potenzial zumindest teilweise nachgeführt ist, insbesondere mit einem Potenzial, das dem Verlauf des an der Sensorstruktur anliegenden Potenzials folgt.

D.h. in einer bevorzugten Ausgestaltung kann der Lenkradkern alternativ oder zusätzlich zu einem anderen Abschirmelement als aktives Abschirmelement betrieben werden, insbesondere alternativ oder zusätzlich zu einem der vorbeschriebenen Abschirmelemente in Form eines flächigen Abschirmelementes oder einer Heizstruktur. Bevorzugt ist der Lenkradkern dabei derart ausgebildet, dass die Beaufschlagung des Lenkradkerns mit dem definierten elektrischen Potenzial eine störende kapazitive Kopplung des Lenkradkerns mit der Sensoreinrichtung reduziert, insbesondere vermeidet. Dadurch kann quasi eine Abschirmung des Lenkradkerns "vor sich selbst" erreicht werden. Insbesondere kann durch das Betreiben des Lenkradkerns als aktives Abschirmelement eine störende, kapazitive Kopplung der Sensoreinrichtung mit dem Lenkradkern reduziert werden.

Ein erfindungsgemäßes Verfahren zum Erkennen einer Anwesenheit einer menschlichen Hand in einem Greifbereich eines Lenkrads ist dadurch gekennzeichnet, dass das Abschirmelement während der Erkennung der Anwesenheit einer menschlichen Hand im Greifbereich des Lenkrads, insbesondere während des Erfassens einer Änderung der kapazitiven Kopplung der zu sensierenden Sensorstruktur mit der Umgebung und/oder einer Referenzelektrode, mit einem definierten, elektrischen Potenzial beaufschlagt wird, das einem während der Erfassung der Änderung der kapazitiven Kopplung an der Sensorstruktur anliegenden Potenzial zumindest teilweise nachgeführt ist.

Nach der Erfindung wird das Abschirmelement dabei, wie bereits im Zusammenhang mit einem erfindungsgemäßen Lenkrad erläutert, mit einem Potenzial beaufschlagt, das dem Verlauf des an der Sensorstruktur anliegenden Potenzials folgt.

Weist die Sensoreinrichtung des Lenkrads wenigstens zwei Sensorstrukturen auf, wird vorzugsweise wenigstens eine Sensorstruktur zumindest zeitweise als Referenzelektrode geschaltet, vorzugsweise sämtliche Sensorstrukturen.

Sind wenigstens zwei Sensorstrukturen zumindest teilweise kämmend angeordnet, wird bevorzugt jeweils die Änderung der kapazitiven Kopplung der Sensorstruktur mit der Umgebung und/oder einer Referenzelektrode erfasst und aus dem Verhältnis der erfassten, jeweils den einzelnen Sensorstrukturen zugeordneten Änderungen der kapazitiven Kopplungen dieser Sensorstrukturen mit der Umgebung und/oder einer Referenzelektrode, eine Position einer menschlichen, im Detektionsbereich der Sensorstrukturen befindlichen Hand bestimmt.

Weist das Lenkrad dabei eine Heizeinrichtung mit wenigstens einer elektrisch leitfähige Heizstruktur zur Heizung des Lenkrades auf, wird vorzugsweise wenigstens eine Heizstruktur als Abschirmelement geschaltet, zumindest während des Erfassens einer Änderung der kapazitiven Kopplung der zu sensierenden Sensorstruktur mit der Umgebung und/oder einer Referenzelektrode, wobei die Heizstruktur dazu mit einem definierten, elektrischen Potenzial beaufschlagt wird, das einem während der Erfassung der Änderung der kapazitiven Kopplung an der Sensorstruktur anliegenden Potenzial zumindest teilweise nachgeführt ist, insbesondere mit einem Potenzial, das dem Verlauf des an der Sensorstruktur anliegenden Potenzial folgt, wobei die Beaufschlagung der Heizstruktur mit dem definierten elektrischen Potenzial vorzugsweise eine Abschirmung der Sensoreinrichtung gegenüber störenden kapazitiven Kopplungen mit Komponenten des Lenkrads bewirkt, insbesondere gegenüber dem Lenkradkern.

D.h. bei einer bevorzugten Ausführung eines erfindungsgemäßen Verfahrens wird wenigstens eine Heizstruktur als aktives Abschirmelement betrieben. Entweder alternativ oder zusätzlich zu einem anderen Abschirmelement.

Wenigstens eine Heizstruktur kann aber auch zumindest zeitweise als Sensorstruktur oder als Referenzelektrode geschaltet und betrieben werden, wobei dazu vorzugsweise die Heizstruktur für die Zeit der Verwendung als Sensorstruktur allpolig abgeschaltet wird.

Weist das Lenkrad einen metallischen Lenkradkern auf, wird vorzugsweise der Lenkradkern als Abschirmelement geschaltet, zumindest während des Erfassens einer Änderung der kapazitiven Kopplung der zu sensierenden Sensorstruktur mit der Umgebung und/oder einer Referenzelektrode, wobei der Lenkradkern dazu mit einem definierten, elektrischen Potenzial beaufschlagt wird, das einem während der Erfassung der Änderung der kapazitiven Kopplung an der Sensorstruktur anliegenden Potenzial zumindest teilweise nachgeführt ist, insbesondere mit einem Potenzial, das dem Verlauf des an der Sensorstruktur anliegenden Potenzial folgt, wobei die Beaufschlagung des Lenkradkerns mit dem definierten elektrischen Potenzial vorzugsweise eine störende kapazitive Kopplung der Sensoreinrichtung mit dem Lenkradkern reduziert, insbesondere vermeidet.

D.h. bei einer anderen bevorzugten Ausführung eines erfindungsgemäßen Verfahrens wird der Lenkradkern als aktives Abschirmelement betrieben. Entweder alternativ oder zusätzlich zu einem anderen Abschirmelement.

Die mit Bezug auf das Lenkrad beschriebenen bevorzugten Ausgestaltung und deren Vorteile gelten selbstverständlich entsprechend für das erfindungsgemäße Verfahren und umgekehrt.

Weitere Merkmale der Erfindung ergeben sich aus den Figuren und der Figurenbeschreibung. Alle vorstehend in der Beschreibung im Zusammenhang mit dem Lenkrad oder dem Verfahren genannten Merkmale und Merkmalskombinationen sowie die nachfolgend in der Figurenbeschreibung genannten und/oder in den Figuren alleine gezeigten Merkmale und Merkmalskombinationen gelten jeweils nicht nur für das Lenkrad sondern auch für das beschriebene Verfahren und sind jeweils nicht nur in den jeweils beschriebenen Kombinationen, sondern auch in anderen technisch ausführbaren Kombinationen bzw. in Alleinstellung verwendbar.

Die Erfindung wird nun anhand mehrerer bevorzugter Ausführungsbeispiele sowie unter Bezugnahme auf die beigefügten Zeichnungen näher erläutert.

Es zeigen schematisch:
- Fig. 1: ein erstes Ausführungsbeispiel eines erfindungsgemäßen Lenkrads in Frontansicht,
- Fig. 2: das erfindungsgemäße Lenkrad aus Fig.1 mit einem erfindungsgemäßen Sensorsystem in Schnittdarstellung in Dickenrichtung,
- Fig. 3: einen Ausschnitt des erfindungsgemäßen Lenkrads aus Fig. 1 in Seitenansicht,
- Fig. 4a: schematisch den Verlauf eines nachgeführten elektrischen Potenzials eines aktiven Abschirmelementes und
- Fig. 4b: den Verlauf eines elektrischen Potenzials eines aktiven Abschirmelementes, der dem Verlauf des an der Sensorstruktur anliegenden elektrischen Potenzial folgt.

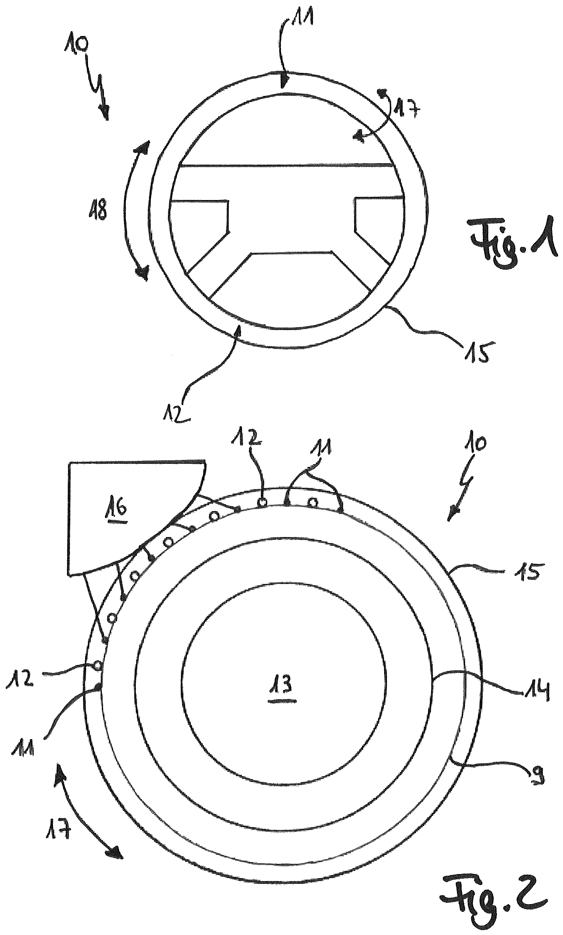

Fig. 1 zeigt ein erstes Ausführungsbeispiel eines erfindungsgemäßen Lenkrads 10 mit einem kapazitiven Sensorsystem in Frontansicht, wobei das Lenkrad 10 eine unterhalb eines Lenkradbezugs 15 angeordnete kapazitive Sensoreinrichtung mit einer Sensorstruktur 11 sowie eine Heizeinrichtung mit einer Heizstruktur 12 aufweist, die in dieser Darstellung allerdings jeweils nur durch einen Bezugspfeil schematisch angedeutet sind. Bei diesem Ausführungsbeispiel erstrecken sich die Sensorstruktur 11 und die Heizstruktur 12 dabei sowohl vollständig umlaufend in Umfassungsrichtung 17, als auch vollständig umlaufend in Umfangsrichtung 18. D.h. die Sensorstruktur 11 und die Heizstruktur 12 erstrecken sich nahezu über einen gesamten Greifbereich der Lenkradfläche.

Fig. 2 zeigt das erfindungsgemäße Lenkrad 10 aus Fig. 1 in einem Schnitt in Dickenrichtung, wobei in dieser Darstellung der Schichtaufbau des Lenkrads 10 gut zu erkennen ist.

Ein im Kernbereich eines Lenkradquerschnittes angeordneter metallischer Lenkradkern 13 bildet die Tragstruktur des Lenkrads 10. In radialer Richtung außerhalb vom Lenkradkern 13, d.h. im Bereich der Außenseite des Lenkradkerns 13, ist ein flächig ausgebildetes und bei diesem Ausführungsbeispiel vollständig umlaufendes Abschirmelement 14 angeordnet, welches den Lenkradkern vollständig umschließt.

Außerhalb vom Abschirmelement 14 und unmittelbar unter dem Lenkradbezug 15 sind die Sensorstruktur 11 und die Heizstruktur 12 angeordnet, wobei die Anordnung der Heizstruktur 12 im Bereich der Außenseite des Abschirmelementes 14 dabei insbesondere in Bezug auf den Wirkungsgrad der Heizeinrichtung bzw. der Heizstruktur 12 vorteilhaft ist, da die abgegebene Heizwärme nicht erst das Abschirmelement passieren muss, bevor sie in den Greifbereich des Lenkrads 10 gelangt.

Die Sensorstruktur 11 und die Heizstruktur 12 sind auf einem Träger 9 aus einem dünnen Stoff aufgestickt und Teil eines erfindungsgemäßen Sensorsystems mit einer kapazitiven Sensoreinrichtung, das zur Erkennung einer Anwesenheit einer menschlichen Hand bzw. eines Fingers 16 im Detektionsbereich der elektrisch leitfähigen Sensorstruktur 11 ausgebildet ist. Das Sensorsystem ist dabei insbesondere zur Erkennung einer Annäherung und/oder Entfernung einer menschlichen Hand bzw. eines Fingers 16 an das Lenkrad 10 ausgebildet, insbesondere zur Hands-On-Off-Erkennung, d.h. zum Erkennen, ob eine menschliche Hand oder ein Teil einer Hand am Lenkrad 10 anliegt oder nicht.

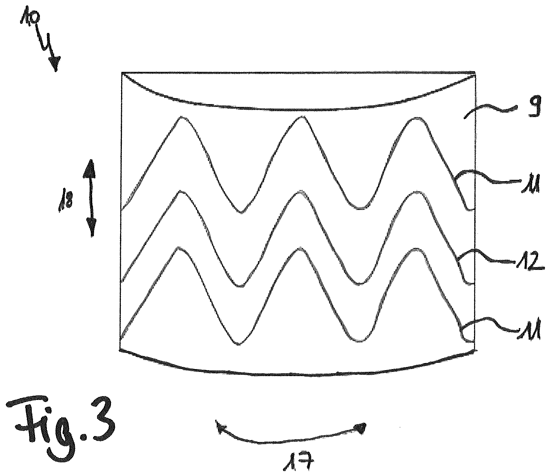

Bei diesem Ausführungsbeispiel werden die Sensorstruktur 11 und die Heizstruktur 12 jeweils durch unterschiedliche, elektrische Leiter in Form von einzelnen Widerstandsdrähten gebildet, welche mäanderförmig auf dem Träger 9 um einen gesamten Umfang in Dickenrichtung, d.h. in Umfassungsrichtung 17 herum verlaufen und in Umfangsrichtung 18 über den gesamten Lenkradumfang verteilt gleichmäßig beabstandet zueinander angeordnet sind, siehe Fig. 3.

Das Erkennen einer Annäherung und/oder einer Entfernung einer menschlichen Hand 16 mittels der kapazitiven Sensoreinrichtung erfolgt dabei nach dem sogenannten "kapazitiven Prinzip", welches darauf beruht, dass die Anwesenheit einer menschlichen Hand im Detektionsbereich der Sensorstruktur 11 bzw. die Annäherung und/oder Entfernung einer menschlichen Hand und/oder eines anderen menschlichen Körperteils an die Sensorstruktur 11 bzw. von dieser weg, eine Änderung der kapazitiven Kopplung der Sensorstruktur 11, in diesem Fall mit der Umgebung, bewirkt, die messtechnisch erfasst werden kann. Aus der erfassten Änderung der kapazitiven Kopplung der Sensorstruktur 11 mit der Umgebung, kann dann auf die Anwesenheit einer menschlichen Hand oder eines Fingers 16 bzw. eine Annäherung und/oder Entfernung einer Hand rückgeschlossen werden.

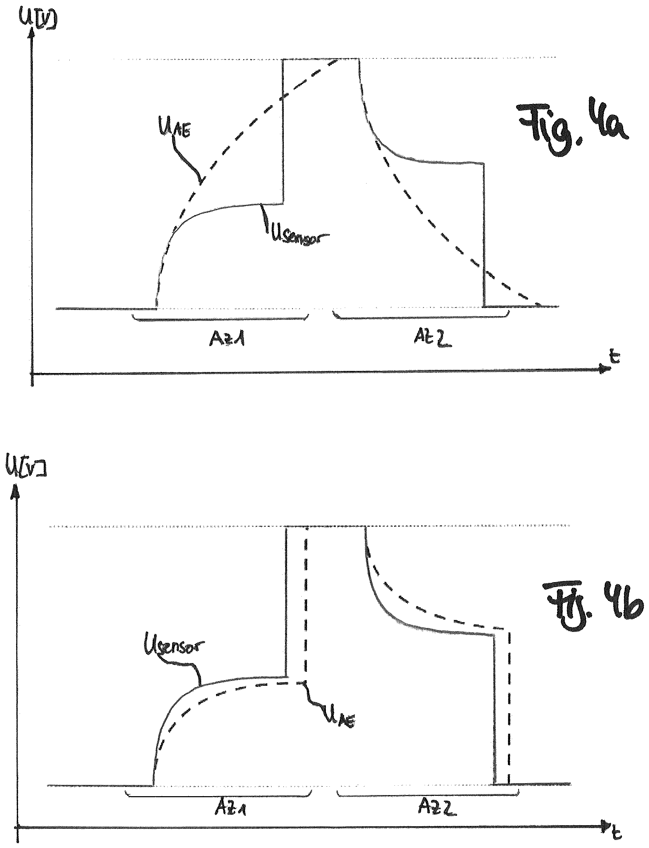

Die Fig. 4a und 4b zeigen schematisch jeweils den Verlauf des an der Sensorstruktur anliegenden elektrischen Potenzials U_{Sensor} während der Erfassung einer Änderung der kapazitiven Kopplung der Sensorstruktur mit der Umgebung bzw. einer Referenzelektrode nach dem CVD-Self- oder Mutual-Verfahren der Firma "Microchip", wobei dieser Verlauf entsteht, in dem während eines ersten Abtastzyklus AZ₁ in einem ersten Schritt im Zeitraum T₁ die Referenzkapazität 170 und die mit der Umgebung und/oder einer Referenzelektrode kapazitiv gekoppelte Sensorstruktur 11 definiert aufgeladen werden, beispielsweise die Referenzkapazität mit 5V und die Sensorstruktur 11, wie gezeigt mit 0V und anschließend in einem Zeitraum T₂ die Referenzkapazität 170 und die Sensorstruktur 11 kurzgeschlossen werden. Dann wird von der Auswerteeinrichtung 130 in einem Zeitraum T₃ das sich zwischen der Referenzkapazität 170 und der Sensorstruktur 11 einstellende Potenzial U_{Sensor} erfasst, das beispielweise 2,5 V beträgt.

Anschließend wird der Vorgang in einem zweiten Abtastzyklus AZ₂ wiederholt, jedoch werden die Referenzkapazität während des Zeitraums T₄ umgekehrt aufgeladen, d.h. die Referenzkapazität jetzt mit 0V und die Sensorstruktur 11 mit 5V. Im Zeitraum T₅ werden diese wieder kurzgeschlossen und das sich einstellende, an der Sensorstruktur 11 anliegende Potenzial U_{Sensor} erfasst.

In Fig. 4a ist zusätzlich zu dem Verlauf des an der Sensorstruktur anliegenden Potenzials U_{Sensor} schematisch ein beispielhafter, vorteilhafter Verlauf eines nachgeführten elektrischen Potenzials U_{AE}, mit dem ein aktives Abschirmelement beaufschlagt werden kann, beispielsweise eine Heizstruktur 12 und/oder ein elektrisch leitendes, flächiges Abschirmelement 14 und/oder der Lenkradkern 13, gezeigt. Dabei nimmt das Potenzial U_{AE} zu, wenn das an der Sensorstruktur 11 anliegende Potenzial U_{Sensor} zunimmt und ab, wenn das an der Sensorstruktur 11 anliegende Potenzial U_{Sensor} abnimmt. Mit einer derartigen Beaufschlagung eines Abschirmelementes kann die Abschirmleistung bereits deutlich verbessert werden.

Ein derartiger Potenzialverlauf U_{AE} kann zum Beispiel durch die Verwendung eines Sensorsystems mit einem Mikrocontroller von der Firma "Microchip" erreicht werden, indem das betreffende Abschirmelement elektrisch mit einem speziell dafür vorgesehenen I/O-Pin am Mikrocontroller angeschlossen wird. Der Mikrocontroller ist entsprechend dazu ausgebildet, diesen Pin in Abhängigkeit vom Zustand der Sensoreinrichtung mit dem gezeigten Potenzialverlauf zu belegen.

Für eine noch bessere Abschirmung, sollte das definierte elektrische Potenzial U_{AE}, mit welchem das Abschirmelement beaufschlagt wird, dem Kurvenverlauf des an der Sensorstruktur 11 anliegenden elektrischen Potenzial U_{Sensor} folgen, vorzugsweise wie in Fig. 4b dargestellt.

Fig. 4b zeigt schematisch den Verlauf eines elektrischen Potenzials U_{AE} eines aktiven Abschirmelementes, das nahezu den gleichen Kurvenverlauf mit nahezu gleichen absoluten Potenzialwerten aufweist wie das an der Sensorstruktur 11 anliegende elektrische Potenzial U_{Sensor} und somit dem Verlauf des an der Sensorstruktur 11 anliegenden elektrischen Potenzials U_{Sensor} folgt.

Dieser Potenzialverlauf U_{AE} kann ebenfalls durch die Verwendung eines Sensorsystems mit einem Mikrocontroller von der Firma "Microchip" erreicht werden, wobei das betreffende Abschirmelement in diesem Fall an einen anderen, dafür vorgesehenen Pin am Mikrocontroller angeschlossen wird, und zwar am sogenannten "DACOUT"-Pin. Der Mikrocontroller ist entsprechend dazu ausgebildet, diesen Pin in Abhängigkeit vom Zustand der Sensoreinrichtung mit dem gezeigten Potenzialverlauf zu belegen. Selbstverständlich ist eine Vielzahl konstruktiver Abwandlungen möglich, insbesondere betreffend die Ausgestaltung und Anordnung der Sensorstrukturen, ohne den Schutzbereich zu verlassen.

## Patentansprüche

1. Lenkrad (10) für ein Kraftfahrzeug mit einem Sensorsystem mit einer kapazitiven Sensoreinrichtung, wobei das Sensorsystem zum Erkennen einer Anwesenheit einer menschlichen Hand (16) in einem Greifbereich des Lenkrads (10) ausgebildet ist und wenigstens eine, in einem Greifbereich des Lenkrads (10) angeordnete, elektrisch leitfähige Sensorstruktur (11) mit einem Detektionsbereich aufweist, wobei das Sensorsystem derart ausgebildet ist, dass die Anwesenheit einer menschlichen Hand (16) im Detektionsbereich der Sensoreinrichtung gegenüber einem Referenzzustand jeweils eine erfassbare, der Sensorstruktur (11) zugeordnete Änderung einer kapazitiven Kopplung der Sensorstruktur (11) bewirkt, wobei das Sensorsystem dazu ausgebildet ist, diese Änderung der kapazitiven Kopplung der zu sensierenden Sensorstruktur (11) zu erfassen, so dass infolgedessen die Anwesenheit einer menschlichen Hand (16) im Greifbereich des Lenkrads (10) erkannt werden kann, wobei das Lenkrad (10) eine Abschirmeinrichtung mit wenigstens einem Abschirmelement (14) aufweist, wobei die Abschirmeinrichtung eine Abschirmung der Sensoreinrichtung gegenüber störenden kapazitiven Kopplungen mit Komponenten des Lenkrads (10) bewirkt,
**dadurch gekennzeichnet, dass** das Sensorsystem dazu ausgebildet ist, die Änderung der kapazitiven Kopplung der zu sensierenden Sensorstruktur (11) mit einer Referenzelektrode zu erfassen, wobei das Abschirmelement (14) elektrisch leitfähig ist und während einer Erfassung der Änderung der kapazitiven Kopplung wenigstens einer Sensorstruktur (11) mit der Referenzelektrode mit einem definierten, elektrischen Potenzial (U_{AE}) beaufschlagbar ist, das einem während der Erfassung der Änderung der kapazitiven Kopplung an der Sensorstruktur (11) anliegenden Potenzial (U_{Sensor}) zumindest teilweise nachgeführt ist.

2. Lenkrad (10) nach Anspruch 1, **dadurch gekennzeichnet, dass** das Sensorsystem dazu ausgebildet ist, die Änderung der kapazitiven Kopplung der zu sensierenden Sensorstruktur (11) mit der Umgebung zu erfassen.

3. Lenkrad (10) nach Anspruch 1 oder 2, **dadurch gekennzeichnet, dass** das elektrisch leitfähige Abschirmelement (14) teilweise flächig ausgebildet ist und eine Außenseite und eine Innenseite aufweist und derart im Lenkrad (10) angeordnet ist, dass die Innenseite dem Lenkradkern (13) zugewandt ist und die Außenseite wenigstens einer Sensorstruktur, wobei das Abschirmelement (14) den Lenkradkern (13) zumindest teilweise umgreift.

4. Lenkrad (10) nach einem der vorgenannten Ansprüche, **dadurch gekennzeichnet, dass** das Lenkrad (10) eine Heizeinrichtung aufweist, wobei die Heizeinrichtung wenigstens eine elektrisch leitfähige Heizstruktur (12) zur Heizung des Lenkrades (10) aufweist, wobei wenigstens eine Heizstruktur (12) ein Abschirmelement (14) bildet und dazu mit einem definierten, elektrischen Potenzial (U_{AE}) beaufschlagbar ist, das einem während der Erfassung der Änderung der kapazitiven Kopplung an der Sensorstruktur (11) anliegenden Potenzial (U_{Sensor}) zumindest teilweise nachgeführt ist, insbesondere mit einem Potenzial (U_{AE}), das dem Verlauf des an der Sensorstruktur (11) anliegenden Potenzials (U_{Sensor}) folgt, wobei die Heizstruktur (12) vorzugsweise derart ausgebildet ist, dass die Beaufschlagung der Heizstruktur (12) mit dem definierten elektrischen Potenzial (U_{AE}) eine Abschirmung der Sensoreinrichtung gegenüber störenden kapazitiven Kopplungen mit Komponenten des Lenkrads (10) bewirkt, insbesondere gegenüber dem Lenkradkern (13).

5. Lenkrad (10) nach einem der vorgenannten Ansprüche, **dadurch gekennzeichnet, dass** das Lenkrad (10) einen metallischen Lenkradkern (13) aufweist, wobei der Lenkradkern (13) vorzugsweise ein Abschirmelement (14) bildet und mit einem definierten, elektrischen Potenzial (U_{AE}) beaufschlagbar ist, das einem während der Erfassung der Änderung der kapazitiven Kopplung an der Sensorstruktur (11) anliegenden Potenzial (U_{Sensor}) zumindest teilweise nachgeführt ist, insbesondere mit einem Potenzial (U_{AE}), das dem Verlauf des an der Sensorstruktur (11) anliegenden Potenzials (U_{Sensor}) folgt, wobei der Lenkradkern (13) insbesondere derart ausgebildet ist, dass die Beaufschlagung des Lenkradkerns (13) mit dem definierten elektrischen Potenzial (U_{AE}) eine störende kapazitive Kopplung des Lenkradkerns (13) mit der Sensoreinrichtung reduziert, insbesondere vermeidet.

6. Verfahren zum Erkennen einer Anwesenheit einer menschlichen Hand (16) in einem Greifbereich eines Lenkrads (10) für ein Kraftfahrzeug, insbesondere zum Erkennen der Anwesenheit einer menschlichen Hand (16) im Greifbereich eines Lenkrads (10), das nach einem der Ansprüche 1 bis 5 ausgebildet ist, wobei das Lenkrad (10) ein Sensorsystem mit einer kapazitiven Sensoreinrichtung aufweist und zum Erkennen einer Anwesenheit einer menschlichen Hand (16) in einem Greifbereich des Lenkrads (10) ausgebildet ist und wenigstens eine, in einem Greifbereich des Lenkrads (10) angeordnete, elektrisch leitfähige Sensorstruktur (11) mit einem Detektionsbereich aufweist, wobei das Sensorsystem derart ausgebildet ist, dass die Anwesenheit einer menschlichen Hand (16) im Detektionsbereich der Sensoreinrichtung gegenüber einem Referenzzustand jeweils eine erfassbare, der Sensorstruktur (11) zugeordnete Änderung einer kapazitiven Kopplung der Sensorstruktur (11) bewirkt, wobei das Sensorsystem dazu ausgebildet ist, diese Änderung der kapazitiven Kopplung der zu sensierenden Sensorstruktur (11) zu erfassen, so dass infolgedessen die Anwesenheit einer menschlichen Hand (16) im Greifbereich des Lenkrads (10) erkannt werden kann, wobei das Lenkrad (10) eine Abschirmeinrichtung mit wenigstens einem elektrisch leitfähigen Abschirmelement (14) aufweist und die Abschirmeinrichtung eine Abschirmung der Sensoreinrichtung gegenüber störenden kapazitiven Kopplungen mit Komponenten des Lenkrads (10) bewirkt, wobei zum Erkennen der Anwesenheit einer menschlichen Hand (16) im Greifbereich des Lenkrads (10) eine Änderung der kapazitiven Kopplung der Sensorstruktur (11) mit der Umgebung und/oder einer Referenzelektrode erfasst wird,
**dadurch gekennzeichnet, dass** das Sensorsystem die Änderung der kapazitiven Kopplung der zu sensierenden Sensorstruktur (11) mit einer Referenzelektrode erfasst, wobei das Abschirmelement (14) während der Erkennung der Anwesenheit einer menschlichen Hand (16) im Greifbereich des Lenkrads, insbesondere während des Erfassens einer Änderung der kapazitiven Kopplung der zu sensierenden Sensorstruktur (11) mit der Referenzelektrode, mit einem definierten, elektrischen Potenzial (U_{AE}) beaufschlagt wird, das einem während der Erfassung der Änderung der kapazitiven Kopplung an der Sensorstruktur (11) anliegenden Potenzial (U_{Sensor}) zumindest teilweise nachgeführt ist.

7. Verfahren nach Anspruch 6, **dadurch gekennzeichnet, dass** das Sensorsystem die Änderung der kapazitiven Kopplung der zu sensierenden Sensorstruktur (11) mit der Umgebung erfasst.

8. Verfahren nach Anspruch 6 oder 7, wobei das Lenkrad (10) eine Heizeinrichtung mit wenigstens einer elektrisch leitfähige Heizstruktur (12) zur Heizung des Lenkrades aufweist,
**dadurch gekennzeichnet, dass** wenigstens eine Heizstruktur (12) als Abschirmelement (14) geschaltet wird, zumindest während des Erfassens einer Änderung der kapazitiven Kopplung der zu sensierenden Sensorstruktur (11) mit der Umgebung und/oder einer Referenzelektrode, wobei die Heizstruktur (12) dazu mit einem definierten, elektrischen Potenzial (U_{AE}) beaufschlagt wird, das einem während der Erfassung der Änderung der kapazitiven Kopplung an der Sensorstruktur (11) anliegenden Potenzial (U_{Sensor}) zumindest teilweise nachgeführt ist, insbesondere mit einem Potenzial (U_{AE}), das dem Verlauf des an der Sensorstruktur (11) anliegenden Potenzial (U_{Sensor}) folgt, wobei die Beaufschlagung der Heizstruktur mit dem definierten elektrischen Potenzial (U_{AE}) vorzugsweise eine Abschirmung der Sensoreinrichtung gegenüber störenden kapazitiven Kopplungen mit Komponenten des Lenkrads (10) bewirkt, insbesondere gegenüber dem Lenkradkern.

9. Verfahren nach einem der Ansprüche 6 bis 8, wobei das Lenkrad (10) einen metallischen Lenkradkern (13) aufweist,
**dadurch gekennzeichnet, dass** der Lenkradkern (13) als Abschirmelement (14) geschaltet wird, zumindest während des Erfassens einer Änderung der kapazitiven Kopplung der zu sensierenden Sensorstruktur (11) mit der Umgebung und/oder einer Referenzelektrode, wobei der Lenkradkern (13) dazu mit einem definierten, elektrischen Potenzial (U_{AE}) beaufschlagt wird, das einem während der Erfassung der Änderung der kapazitiven Kopplung an der Sensorstruktur (11) anliegenden Potenzial (U_{Sensor}) zumindest teilweise nachgeführt ist, insbesondere mit einem Potenzial (U_{AE}), das dem Verlauf des an der Sensorstruktur (11) anliegenden Potenzial (U_{Sensor}) folgt, wobei die Beaufschlagung des Lenkradkerns mit dem definierten elektrischen Potenzial (U_{AE}) vorzugsweise eine störende kapazitive Kopplung des Lenkradkerns (13) mit der Sensoreinrichtung reduziert, insbesondere vermeidet.

## Claims

1. Steering wheel (10) for a motor vehicle, having a sensor system with a capacitive sensor device, wherein the sensor system is designed to detect a presence of a human hand (16) in a gripping area of the steering wheel (10) and has at least one electrically conductive sensor structure (11) which is arranged in a gripping area of the steering wheel (10) and has a detection area, wherein the sensor system is designed in such a manner that the presence of a human hand (16) in the detection area of the sensor device respectively causes, in comparison with a reference state, a capturable change in capacitive coupling of the sensor structure (11), which change is assigned to the sensor structure (11), wherein the sensor system is designed to capture this change in the capacitive coupling of the sensor structure (11) to be sensed, with the result that the presence of a human hand (16) in the gripping area of the steering wheel (10) can consequently be detected, wherein the steering wheel (10) has a screening device with at least one screening element (14), wherein the screening device screens the sensor device from interfering capacitive couplings to components of the steering wheel (10),
**characterized in that** the sensor system is designed to capture the change in the capacitive coupling of the sensor structure (11) to be sensed to a reference electrode, wherein the screening element (14) is electrically conductive and a defined electrical potential (U_{AE}) which is at least partially tracked to a potential (U_{Sensor}) applied to the sensor structure (11) during the capture of the change in the capacitive coupling can be applied to said screening element during capture of the change in the capacitive coupling of at least one sensor structure (11) to the reference electrode.

2. Steering wheel (10) according to Claim 1, **characterized in that** the sensor system is designed to capture the change in the capacitive coupling of the sensor structure (11) to be sensed to the environment.

3. Steering wheel (10) according to Claim 1 or 2, **characterized in that** the electrically conductive screening element (14) is partially flat and has an outer surface and an inner surface and is arranged in the steering wheel (10) in such a manner that the inner surface faces the steering wheel core (13) and the outer surface faces at least one sensor structure, wherein the screening element (14) at least partially engages around the steering wheel core (13).

4. Steering wheel (10) according to one of the above-mentioned claims, **characterized in that** the steering wheel (10) has a heating device, wherein the heating device has at least one electrically conductive heating structure (12) for heating the steering wheel (10), wherein at least one heating structure (12) forms a screening element (14) and a defined electrical potential (U_{AE}) which is at least partially tracked to a potential (U_{Sensor}) applied to the sensor structure (11) during the capture of the change in the capacitive coupling, in particular a potential (U_{AE}) which follows the profile of the potential (U_{Sensor}) applied to the sensor structure (11), can be applied to said heating structure for this purpose, wherein the heating structure (12) is preferably designed in such a manner that the application of the defined electrical potential (U_{AE}) to the heating structure (12) screens the sensor device from interfering capacitive couplings to components of the steering wheel (10), in particular from the steering wheel core (13).

5. Steering wheel (10) according to one of the above-mentioned claims, **characterized in that** the steering wheel (10) has a metal steering wheel core (13), wherein the steering wheel core (13) preferably forms a screening element (14) and a defined electrical potential (U_{AE}) which is at least partially tracked to a potential (U_{Sensor}) applied to the sensor structure (11) during the capture of the change in the capacitive coupling, in particular a potential (U_{AE}) which follows the profile of the potential (U_{Sensor}) applied to the sensor structure (11), can be applied to said steering wheel core, wherein the steering wheel core (13) is designed, in particular, in such a manner that the application of the defined electrical potential (U_{AE}) to the steering wheel core (13) reduces, in particular avoids, interfering capacitive coupling of the steering wheel core (13) to the sensor device.

6. Method for detecting a presence of a human hand (16) in a gripping area of a steering wheel (10) for a motor vehicle, in particular for detecting the presence of a human hand (16) in the gripping area of a steering wheel (10) which is designed according to one of Claims 1 to 5, wherein the steering wheel (10) has a sensor system with a capacitive sensor device and is designed to detect a presence of a human hand (16) in a gripping area of the steering wheel (10) and has at least one electrically conductive sensor structure (11) which is arranged in a gripping area of the steering wheel (10) and has a detection area, wherein the sensor system is designed in such a manner that the presence of a human hand (16) in the detection area of the sensor device respectively causes, in comparison with a reference state, a capturable change in capacitive coupling of the sensor structure (11), which change is assigned to the sensor structure (11), wherein the sensor system is designed to capture this change in the capacitive coupling of the sensor structure (11) to be sensed, with the result that the presence of a human hand (16) in the gripping area of the steering wheel (10) can be consequently detected, wherein the steering wheel (10) has a screening device with at least one electrically conductive screening element (14) and the screening device screens the sensor device from interfering capacitive couplings to components of the steering wheel (10), wherein, in order to detect the presence of a human hand (16) in the gripping area of the steering wheel (10), a change in the capacitive coupling of the sensor structure (11) to the environment and/or to a reference electrode is captured,
**characterized in that** the sensor system captures the change in the capacitive coupling of the sensor structure (11) to be sensed to a reference electrode, wherein a defined electrical potential (U_{AE}) which is at least partially tracked to a potential (U_{Sensor}) applied to the sensor structure (11) during the capture of the change in the capacitive coupling is applied to the screening element (14) during the detection of the presence of a human hand (16) in the gripping area of the steering wheel, in particular during the capture of a change in the capacitive coupling of the sensor structure (11) to be sensed to the reference electrode.

7. Method according to Claim 6, **characterized in that** the sensor system captures the change in the capacitive coupling of the sensor structure (11) to be sensed to the environment.

8. Method according to Claim 6 or 7, wherein the steering wheel (10) has a heating device with at least one electrically conductive heating structure (12) for heating the steering wheel,
**characterized in that** at least one heating structure (12) is connected as a screening element (14) at least during the capture of a change in the capacitive coupling of the sensor structure (11) to be sensed to the environment and/or to a reference electrode, wherein a defined electrical potential (U_{AE}) which is at least partially tracked to a potential (U_{Sensor}) applied to the sensor structure (11) during the capture of the change in the capacitive coupling, in particular a potential (U_{AE}) which follows the profile of the potential (U_{Sensor}) applied to the sensor structure (11), is applied to the heating structure (12) for this purpose, wherein the application of the defined electrical potential (U_{AE}) to the heating structure preferably screens the sensor device from interfering capacitive couplings to components of the steering wheel (10), in particular from the steering wheel core.

9. Method according to one of Claims 6 to 8, wherein the steering wheel (10) has a metal steering wheel core (13),
**characterized in that** the steering wheel core (13) is connected as a screening element (14) at least during the capture of a change in the capacitive coupling of the sensor structure (11) to be sensed to the environment and/or to a reference electrode, wherein a defined electrical potential (U_{AE}) which is at least partially tracked to a potential (U_{Sensor}) applied to the sensor structure (11) during the capture of the change in the capacitive coupling, in particular a potential (U_{AE}) which follows the profile of the potential (U_{Sensor}) applied to the sensor structure (11), is applied to the steering wheel core (13) for this purpose, wherein the application of the defined electrical potential (U_{AE}) to the steering wheel core preferably reduces, in particular avoids, interfering capacitive coupling of the steering wheel core (13) to the sensor device.

## Revendications

1. Volant de direction (10) pour un véhicule automobile, comprenant un système capteur comprenant un dispositif capteur capacitif, le système capteur étant configuré pour reconnaître une présence d'une main humaine (16) dans une zone de préhension du volant de direction (10) et possédant au moins une structure de capteur (11) électriquement conductrice, disposée dans une zone de préhension du volant de direction (10) et ayant une zone de détection, le système capteur étant configuré de telle sorte que la présence d'une main humaine (16) dans la zone de détection du dispositif capteur produit à chaque fois une modification détectable par rapport à un état de référence, associée à la structure de capteur (11), d'un couplage capacitif de la structure de capteur (11), le système capteur étant configuré pour détecter cette modification du couplage capacitif de la structure de capteur (11) à détecter, de sorte que la présence d'une main humaine (16) dans la zone de préhension du volant de direction (10) peut être reconnue en conséquence de cela, le volant de direction (10) possédant un dispositif de blindage comprenant au moins un élément de blindage (14), le dispositif de blindage produisant un blindage du dispositif capteur par rapport aux couplages capacitifs parasites avec les composants du volant de direction (10),
**caractérisé en ce que** le système capteur est configuré pour détecter la modification du couplage capacitif de la structure de capteur (11) à détecter avec une électrode de référence, l'élément de blindage (14) étant électriquement conducteur et, pendant une détection de la modification du couplage capacitif d'au moins une structure de capteur (11) avec l'électrode de référence, pouvant être chargé avec un potentiel électrique (U_{AE}) défini qui est au moins partiellement asservi à un potentiel (U_{Sensor}) appliqué à la structure de capteur (11) pendant la détection de la modification du couplage capacitif.

2. Volant de direction (10) selon la revendication 1, **caractérisé en ce que** le système capteur est configuré pour détecter la modification du couplage capacitif de la structure de capteur (11) à détecter avec l'environnement.

3. Volant de direction (10) selon la revendication 1 ou 2, **caractérisé en ce que** l'élément de blindage (14) électriquement conducteur est de configuration partiellement plane et possède un côté extérieur ainsi qu'un côté intérieur et est disposé dans le volant de direction (10) de telle sorte que le côté intérieur fait face à l'âme de volant de direction (13) et le côté extérieur à au moins une structure de capteur, l'élément de blindage (14) enveloppant au moins partiellement l'âme de volant de direction (13).

4. Volant de direction (10) selon l'une des revendications précédentes, **caractérisé en ce que** le volant de direction (10) possède un dispositif de chauffage, le dispositif de chauffage possédant au moins une structure chauffante (12) électriquement conductrice destinée à chauffer le volant de direction (10), au moins une structure chauffante (12) formant un élément de blindage (14) et pouvant en outre être chargée avec un potentiel électrique (U_{AE}) défini qui est au moins partiellement asservi à un potentiel (U_{Sensor}) appliqué à la structure de capteur (11) pendant la détection de la modification du couplage capacitif, notamment avec un potentiel (U_{AE}) qui suit le tracé du potentiel (Usensor) appliqué à la structure de capteur (11), la structure chauffante (12) étant de préférence configurée de telle sorte que la charge de la structure chauffante (12) avec le potentiel électrique (U_{AE}) défini produit un blindage du dispositif capteur par rapport aux couplages capacitifs parasites avec les composants du volant de direction (10), notamment par rapport à l'âme de volant de direction (13).

5. Volant de direction (10) selon l'une des revendications précédentes, **caractérisé en ce que** le volant de direction (10) possède une âme de volant de direction (13) métallique, l'âme de volant de direction (13) formant de préférence un élément de blindage (14) et pouvant être chargée avec un potentiel électrique (U_{AE}) défini qui est au moins partiellement asservi à un potentiel (U_{Sensor}) appliqué à la structure de capteur (11) pendant la détection de la modification du couplage capacitif, notamment avec un potentiel (U_{AE}) qui suit le tracé du potentiel (U_{Sensor}) appliqué à la structure de capteur (11), l'âme de volant de direction (13) étant notamment configurée de telle sorte que la charge de l'âme de volant de direction (13) avec le potentiel électrique (U_{AE}) défini réduit, notamment évite, un couplage capacitif parasite de l'âme de volant de direction (13) avec le dispositif capteur.

6. Procédé pour reconnaître une présence d'une main humaine (16) dans une zone de préhension d'un volant de direction (10) pour un véhicule automobile, notamment pour reconnaître la présence d'une main humaine (16) dans la zone de préhension d'un volant de direction (10) qui est configuré selon l'une des revendications 1 à 5, le volant de direction (10) possédant un système capteur comprenant un dispositif capteur capacitif et étant configuré pour reconnaître une présence d'une main humaine (16) dans une zone de préhension du volant de direction (10) et possédant au moins une structure de capteur (11) électriquement conductrice, disposée dans une zone de préhension du volant de direction (10) et ayant une zone de détection, le système capteur étant configuré de telle sorte que la présence d'une main humaine (16) dans la zone de détection du dispositif capteur produit à chaque fois une modification détectable par rapport à un état de référence, associée à la structure de capteur (11), d'un couplage capacitif de la structure de capteur (11), le système capteur étant configuré pour détecter cette modification du couplage capacitif de la structure de capteur (11) à détecter, de sorte que la présence d'une main humaine (16) dans la zone de préhension du volant de direction (10) peut être reconnue en conséquence de cela, le volant de direction (10) possédant un dispositif de blindage comprenant au moins un élément de blindage (14) électriquement conducteur et le dispositif de blindage produisant un blindage du dispositif capteur par rapport aux couplages capacitifs parasites avec les composants du volant de direction (10), une modification du couplage capacitif de la structure de capteur (11) avec l'environnement et/ou une électrode de référence étant détectée en vue de reconnaître la présence d'une main humaine (16) dans la zone de préhension du volant de direction (10), **caractérisé en ce que** le système capteur détecte la modification du couplage capacitif de la structure de capteur (11) à détecter avec une électrode de référence, l'élément de blindage (14), pendant la détection de la présence d'une main humaine (16) dans la zone de préhension du volant de direction, notamment pendant la détection d'une modification du couplage capacitif de la structure de capteur (11) à détecter avec l'électrode de référence, étant chargé avec un potentiel électrique (U_{AE}) défini qui est au moins partiellement asservi à un potentiel (U_{Sensor}) appliqué à la structure de capteur (11) pendant la détection de la modification du couplage capacitif.

7. Procédé selon la revendication 6, **caractérisé en ce que** le système capteur détecte la modification du couplage capacitif de la structure de capteur (11) à détecter avec l'environnement.

8. Procédé selon la revendication 6 ou 7, le volant de direction (10) possédant un dispositif de chauffage comprenant au moins une structure chauffante (12) électriquement conductrice destinée à chauffer le volant de direction, **caractérisé en ce qu'**au moins une structure chauffante (12) est commutée en tant qu'élément de blindage (14), au moins pendant la détection d'une modification du couplage capacitif de la structure de capteur (11) à détecter avec l'environnement et/ou une électrode de référence, la structure chauffante (12) étant à cet effet chargée avec un potentiel électrique (U_{AE}) défini qui est au moins partiellement asservi à un potentiel (U_{Sensor}) appliqué à la structure de capteur (11) pendant la détection de la modification du couplage capacitif, notamment avec un potentiel (U_{AE}) qui suit le tracé du potentiel (U_{Sensor}) appliqué à la structure de capteur (11), la charge de la structure chauffante avec le potentiel électrique (U_{AE}) défini produisant de préférence un blindage du dispositif capteur par rapport aux couplages capacitifs parasites avec les composants du volant de direction (10), notamment par rapport à l'âme de volant de direction.

9. Procédé selon l'une des revendications 6 à 8, le volant de direction (10) possédant une âme de volant de direction (13) métallique, **caractérisé en ce que** l'âme de volant de direction (13) est commutée en tant qu'élément de blindage (14), au moins pendant la détection d'une modification du couplage capacitif de la structure de capteur (11) à détecter avec l'environnement et/ou une électrode de référence, l'âme de volant de direction (13) étant à cet effet chargée avec un potentiel électrique (U_{AE}) défini qui est au moins partiellement asservi à un potentiel (U_{Sensor}) appliqué à la structure de capteur (11) pendant la détection de la modification du couplage capacitif, notamment avec un potentiel (U_{AE}) qui suit le tracé du potentiel (U_{Sensor}) appliqué à la structure de capteur (11), la charge de l'âme de volant de direction avec le potentiel électrique (U_{AE}) défini réduisant, notamment évitant, un couplage capacitif parasite de l'âme de volant de direction (13) avec le dispositif capteur.
